# EUROPÄISCHE PATENTSCHRIFT

(11) **EP 0 541 919 B1**
(45) Veröffentlichungstag und Bekanntmachung des Hinweises auf die Patenterteilung: **29.03.1995**
(21) Anmeldenummer: 92114604.9
(22) Anmeldetag: 27.08.1992
(51) Int. Cl.: H01J 37/34, C23C 14/34

(54) **Vorrichtung zur Beschichtung von Substraten für Kathodenzerstäubungsanlagen**
Cathodic sputtering apparatus for coating substrates
Dispositif de pulvérisation cathodique pour le revêtement des substrats

(30) Priorität: 11.11.1991 DE 4136951
(43) Veröffentlichungstag der Anmeldung: 19.05.1993
(73) Patentinhaber: LEYBOLD AKTIENGESELLSCHAFT, D-63450 Hanau (DE)
(72) Erfinder: Lübbehusen, Michael, Dr., W-6454 Bruchköbel (DE)

(56) Entgegenhaltungen:
- EP-A- 0 144 838
- EP-A- 0 148 470
- EP-A- 0 316 523
- DE-C- 4 127 262

## Beschreibung

Die Erfindung bezieht sich auf eine Vorrichtung zur Beschichtung von Substraten für Kathodenzerstäubungsanlagen, mit einem großflächigen Target, auf dem das abzutragende Material in einer, einen ersten geschlossenen Bereich bildenden, Bahn angeordnet ist, und einer Magnetanordnung, die ein Magnetfeld erzeugt, dessen Feldlinien bogenförmig das bahnförmige Target in Querrichtung überspannen.

Auf dem Gebiet der Beschichtung großflächiger Substrate mittels Kathodenstrahlzerstäubungstechnik wurden bislang eine Reihe von Verbesserungen erzielt, die eine kontrollierte und weitgehend gleichmäßige Filmabscheidung, vorzugsweise bestehend aus metallischen oder metalloxidischen Substanzen, auf Substrate ermöglichen. Wesentliche Faktoren für die Herstellung derartig gleichmäßiger und großflächiger Schichten auf Substraten ist u.a. die Form, Größe und Anordnung der Targetkörper sowie deren Stromversorgung.

Ferner sind Kathodenzerstäubungsanlagen bekannt, deren Targets, die für gewöhnlich auf Kathodenpotential liegen, mit einer besonderen Magnetanordnung versehen sind. Die. damit erzeugbaren magnetischen Feldlinien sind dabei derart orientiert, daß sie bogenförmig die Targetoberflächen überspannen. Dadurch werden die Abtragungsraten auf der Targetoberfläche und in Zusammenhang damit die Schichtdickenbildung pro Zeiteinheit auf dem Substart erhöht. Kathodenzerstäubungsanlagen derartiger Bauart werden beispielsweise in der DE-PS 34 11 563 oder der US-PS 41 66 018 beschrieben.

Bei der Beschichtung von großflächigen Substraten mittels Kathodenzerstäubungsanlagen werden jedoch häufig Entladungslichtbögen beobachtet, die ihre Ursache in physikalischen oder chemischen Inhomogenitäten auf der Targetoberfläche haben. Gerade der sogenannte "reaktive" Betrieb von Kathodenzerstäubungsanlagen, bei dem zusätzlich zu dem Sputtergas, das für gewöhnlich das Edelgas Argon ist, ein weiteres Gas, wie z. B. Sauerstoff, beigemischt wird, welches chemisch mit dem Targetmaterial reagiert, führt vermehrt zu den vorgenannten Lichtbogeneffekten, die sich nachteilig auf den Zerstäubungsprozess auswirken. So verursacht jeder einzelne Lichtbogen auf der Oberflache des Targets einen inhomogenen lokalen Energieeintrag, der im Extremfall bis zur Target- und zur Substratzerstörung führen kann. In aller Regel sind jedoch zumindest störende Inhomogenitäten bei der Schichtenbildung auf dem Substrate die Folge.

Um die negativen Auswirkungen derartiger Lichtbögen zu vermeiden, kann man die Sputterstromversorgnung so auslegen, daß das elektrische Feld am Target einem periodischen Potentialverlauf unterliegt, der kürzer oder höchstens gleich der mittleren Enstehungszeit eines Lichtbogens ist, sodaß die für den Zerstäubungsprozeß nachteiligen Bogenentladungen sich gar nicht erst ausbilden können.

Zur Unterdrückung derartiger Lichtbogenentladungen sind Kathodenzerstäubungsanlagen bekannt, deren Sputterstromversorgung mit Wechselstrom vorgenommen wird, so daß das Spannungspotential für gewöhnlich einem sinusförmigen Verlauf unterliegt.

Für die Beschichtung großflächiger Substratflächen sind entsprechend den Ausmaßen der zu beschichtenden Substrate geeignet große Targetkörper vorzusehen, die in an sich bekannter Weise innerhalb des Rezipienten nebeneinander angeordnet sind. Zur Beschichtung werden die Substrate in einem definierten Abstand an den Targetkörpern vorbeigeführt, um an ihnen großflächig eine bestimmte Sollschichtdicke abscheiden zu können.

Hierzu hat sich eine typische Targetkathodenform als besonders geeignet herausgebildet, die als "Racetrack" bezeichnet, zwei parallel verlaufende Bahnabschnitte aufweist, deren Endbereiche mit jeweils einem halbkreisförmigen Segegment verbunden sind.

Nachteilhaft bei derartigen Anlagen ist jedoch der große Raumbedarf, der durch die Aneinanderreihung einzelner "Racetracks" verursacht wird.

Der Erfindung liegt daher die Aufgabe zugrunde eine Vorrichtung zur Beschichtung von Substraten für Kathodenzerstäubungsanlagen, mit einem großflächigen Target, auf dem das abzutragende Material in einer, einen ersten geschlossenen Bereich bildenden Bahn, angeordnet ist, und einer Magnetanordnung, die ein Magnetfeld erzeugt, dessen Feldlinien bogenförmig das bahnförmige Target in Querrichtung überspannen, anzugeben, bei der die die Oberflache der Targetkörper zerstörenden Lichtbogenentladungen vermieden wird und die bei gleicher Effizienz wie herkömmliche Kathodenzerstäubungsanlagen den Raumbedarf, den Bauaufwand und den Kostenaufwand erheblich reduziert.

Eine erfindungsgemäße Lösung dieser Aufgabe ist im Anspruch 1 angegeben. Weiterbildungen der Erfindung sind Gegenstand der Unteransprüche.

Erfindungsgemäß ist die Vorrichtung zur Beschichtung von Substraten für Kathodenzerstäubungsanlagen, mit einem großflächigen Target, auf dem das abzutragende Material in einer, einen ersten geschlossenen Bereich bildenden Bahn angeordnet ist, und einer Magnetanordnung, die ein Magnetfeld erzeugt, dessen Feldlinien bogenförmig das bahnförmige Target in Querrichtung überspannen derart ausgebildet, daß wenigstens ein weiterer geschlossener Bereich vorgesehen ist, der aus einem bahnförmig angeordneten, abzutragenden Material gebildet ist, und der den ersten geschlossenen Bereich umgibt, und das die Bahn des ersten und die Bahnen der weiteren geschlossenen Bereiche jeweils voneinander elektrisch isoliert sind.

Die Racetracks sind erfindungsgemäß derart paarweise ineinander und voneinander elektrisch isoliert angeordnet, so daß zwischen beiden Racetracks eine Wechselstromversorgung angelegt werden kann, deren Strombeiträge zwischen dem einen und dem anderen Racetrack alternieren. Vorzugsweise bedient man sich hierbei der sogenannten Mittelfrequenzstromversorgung, bei der in Abfolge je eine Halbwelle des Wechselstroms auf ein Racetrack und die nächste auf das andere Racetrack übertragen wird. Dabei erfährt abwechselnd jeweils ein Racetrack pro Racetrack-Paar einen zeitlich variablen Stromfluß, in dessen kurzer Zeitdauer die Ausbildung von Lichtbögen vermeidbar ist.

Zwar sind Kathodenzerstäubungsanlagen bekannt, in denen die Racetracks räumlich nebeneinander beabstandet angeordnet sind, doch bedürfen diese Anlagen wesentlich größere Rezipientengehäuse bei vergleichsweise gleicher Targetoberfläche.

Die erfindungsgemäße geometrische Anordnung der beiden Racetracks führt hingegen zu einem erheblich reduzierten Raumbedarf und einem deutlich geringerem Bauaufwand der Kathodenzerstäubungsanlage, im Vergleich zu den vorgenannten Anordnungen.

Ferner ist aufgrund der symmetrischen Anordnung der Racetracks mit alternierender Stromversorgung ein stabilerer Abscheideprozeß möglich, als mit je zwei baulich voneinander getrennten Kathodenanordnungen.

Die Erfindung wird nachstehend ohne Beschränkung des allgemeinen Erfindungsgedankens anhand eines Ausführungsbeispiels unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:

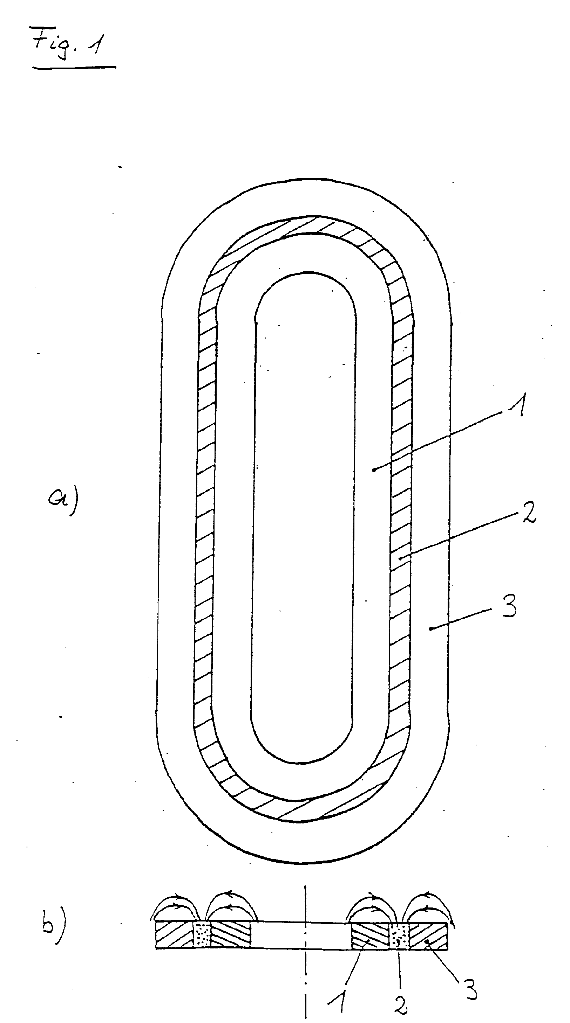

- Fig. 1a: Draufsicht auf die Kathodenanordnung
- Fig. 1b: Querschnitt durch die Kathodenanordnung

Figur 1a zeigt eine Draufsicht auf die Kathodenanordnung, die aus einem inneren Racetrack 1, einer elektrischen Isolationsschicht 2 und einem zweiten Racetrack 3 besteht. Zum Unterschied zu zwei nebeneinader liegenden Targetkörpern ist die Kathodenumgebung bei der erfindungsgemäßen Anordnug nur halb so groß, was sich auch in einem nur halb so großen Rezipientengehäuse wiederspiegelt.

Figur 1b zeigt einen Querschnitt durch die Kathodenanordnung und verdeutlicht den Verlauf der magnetischen Feldlinien. Auf die zeichnerische Darstellung der einzelnen Magnete wird in der Abbildung verzichtet; vielmehr wird hierzu auf die Druckschriften DE-PS 34 11 563 sowie US-PS 41 66 018 verwiesen. Die beiden Racetracks 1 und 3 werden jeweils im Zwischenraum über ihre gesamte Umfangslänge durch eine elektrische Isolationsschicht 2 voneinander getrennt.

Besonders geeignet ist diese Magnetronanordnug zur reaktiven Abscheidung von Siliziumdioxidschichten von einem Siliziumtarget, da gerade bei diesen Prozessen mit herkömmlichen Gleichstromkathodenzerstäubungsanlagen vermehrt Bogenentladungen auftreten.

Mit der erfindungsgemäßen Magnetronanordnung ist man darüberhinaus in der Lage Mischungen aus zwei unterschiedlichen Materialien auf Substrate abzuscheiden, wenn die Racetracks 1 und 2 aus verschiedene Materialien bestehen. Unter Verwendung von Reaktivgasen als Zusatzgas können somit insbesondere auch beliebige Reaktivprodukte auf Substrate abgeschieden werden.

Es bleibt jedoch zu berücksichtigen, daß die Abtragrate unterschiedlicher Targetmaterialien bei gleichen Potentialverhältnissen unterschiedlich sein kann. Mit einer individuellen Einstellung der Racetrack-Potentiale, z.B. über die Sputterstromversorgung ist jedoch ein Regulativ geschaffen, mit dem bestimmte Abtragraten beiliebig einstellbar sind, sodaß beliebige graduelle Schichtenfolgen auf Substraten denkbar sind.

Natürlich lassen sich bei entsprechender Erweiterung der Anzahl ineinandergeschachtelter Racetracks mehrere Materialien in beliebiger Mischung und Abfolge auf Substrate aufbringen.

Für die Verwendung bestimmter, meist nicht reaktiver Sputterprozesse, reicht i. a. eine Gleichstromversorgung aus, da hier in der Regel keine oder nur sehr energiearme Bogenentladungen auftreten.

Durch die vorliegende erfindungsgemäße Vorrichtung ist somit erstmals die Möglichkeit geschaffen worden, eine kompakte und kostengünstige Kathodenzerstäubungsanlage anzugeben, die über eine einfache Regelung der Potentialverhältnisse an den Magnetronkathoden großflächiges Beschichten von Substratflächen ermöglicht.

## Patentansprüche

1. Vorrichtung zur Beschichtung von Substraten für Kathodenzertstäubungsanlagen,
mit einem großflächigen Target, auf dem das abzutragende Material in einer, einen ersten geschlossenen Bereich bildenden, Bahn angeordnet ist, und
einer Magnetanordnung, die ein Magnetfeld erzeugt, dessen Feldlinien bogenförmig das bahnförmige Target in Querrichtung überspannen,
dadurch **gekennzeichnet**, daß wenigstens ein weiterer geschlossener Bereich vorgesehen ist, der aus einem bahnförmig angeordneten, abzutragenden Material gebildet ist, und der den ersten geschlossenen Bereich umgibt, und daß die Bahn des ersten und die Bahnen der weiteren geschlossenen Bereiche jeweils voneinander elektrisch isoliert sind.

2. Vorrichtung nach Anspruch 1,
dadurch **gekennzeichnet**, daß der bahnförmig geschlossene Bereich des abzutragenden Targetmaterials zwei parallel verlaufende Abschnitte aufweist, deren Endbereiche mit jeweils einem halbkreisförmigen Segment verbunden sind.

3. Vorrichtung nach Anspruch 1 oder 2,
dadurch **gekennzeichnet**, daß der Abstand zwischen zwei, elektrisch voneinander getrennten Targetbereichen über deren gesamte Umfangslänge gleich ist.

4. Vorrichtung nach einem der Ansprüche 1 bis 3,
dadurch **gekennzeichnet**, daß die Targetbereiche auf Kathodenpotential liegen.

5. Vorrichtung nach einem der Ansprüche 1 bis 4,
dadurch **gekennzeichnet**, daß die Stromversorgung zwischen den elektrisch voneinander isolierten Targetbereichen alternierend vornehmbar ist.

6. Vorrichtung nach Anspruch 5,
dadurch **gekennzeichnet**, daß die elektrisch voneinander isolierten Targetbereiche abwechselnd mit den aufeinanderfolgenden Halbwellen eines Wechselstroms beaufschlagbar sind.

7. Vorrichtung nach Anspruch 6,
dadurch **gekennzeichnet**, daß sich die-Halbwellen in Form und Amplitude voneinander unterscheiden können.

8. Vorrichtung nach einem der Ansprüche 5 bis 7,
dadurch **gekennzeichnet**, daß die Wechselstromfrequenz zwischen 1 und 100 kHZ beträgt.

9. Vorrichtung nach einem der Ansprüche 1 bis 8,
dadurch **gekennzeichnet**, daß die elektrisch voneinander isolierten Targetbereiche mit zwei unabhängigen Gleichstrom-Versogungseinheiten verbindbar sind.

10. Vorrichtung nach einem der Ansprüche 1 bis 8,
dadurch **gekennzeichnet**, daß das Targetmaterial aus reinem oder dotierten Silizium oder einer überwiegend Silizium enthaltenden Legierung besteht.

11. Vorrichtung nach einem der Ansprüche 1 bis 9.
dadurch **gekennzeichnet**, daß die einzelnen in sich geschlossenen Targetbereiche aus unterschiedlichen Targetmaterialien bestehen.

## Claims

1. Apparatus for coating substrates for cathodic sputtering systems and having a target which covers a large area and on which the material to be removed is disposed in a strip forming a first closed area, and having a magnet arrangement which generates a magnetic field of which the field lines in an arcuate manner span the strip-like target in the transverse direction, characterized in that at least one further closed area is provided which is formed of a material to be removed disposed in a strip-like manner and which surrounds the first closed area; and in that the strip of the first closed area and the strips of the further closed areas are electrically insulated from one another in each case.

2. Apparatus according to Claim 1, characterized in that the strip-like closed area of the target material to be removed comprises two parallel portions of which the end regions are each connected to a semicircular segment.

3. Apparatus according to Claim 1 or 2, characterized in that the spacing between two target areas which are electrically separated from one another is the same over their entire peripheral lengths.

4. Apparatus according to any one of Claims 1 to 3, characterized in that the target areas are at cathode potential.

5. Apparatus according to any one of Claims 1 to 4, characterized in that the current can be supplied in an alternating manner between the target areas which are electrically insulated from one another.

6. Apparatus according to Claim 5, characterized in that the target areas which are electrically insulated from one another can be acted upon alternately by the successive half-waves of an alternating current.

7. Apparatus according to Claim 6, characterized in that the half-waves can differ from one another in shape and amplitude.

8. Apparatus according to any one of Claims 5 to 7, characterized in that the alternating current frequency is between 1 and 100 kHZ.

9. Apparatus according to any one of Claims 1 to 8, characterized in that the target areas which are electrically insulated from one another can be connected to two independent direct-current supply units.

10. Apparatus according to any one of Claims 1 to 8, characterized in that the target material consists of pure or doped silicon or an alloy predominantly containing silicon.

11. Apparatus according to any one of Claims 1 to 9, characterized in that the individual self-contained target areas consist of different target materials.

## Revendications

1. Dispositif pour le revêtement de substrats pour des systèmes de pulvérisation cathodique, comprenant une cible à grande surface, sur laquelle le matériau à enlever est disposé en une bande, formant une première région close, et comprenant un agencement magnétique, qui produit un champ magnétique dont les lignes de champ chevauchent en courbe transversalement la cible en forme de bande, caractérisé en ce qu'il est prévu au moins une autre région close, formée d'un matériau à enlever disposé en forme de bande et entourant la première région close, et en ce que la bande de la première région et les bandes des autres régions closes sont isolées électriquement les unes des autres.

2. Dispositif selon la revendication 1, caractérisé en ce que la région close en forme de bande du matériau de cible à enlever présente deux segments parallèles, dont les zones d'extrémité sont raccordées chacune par un segment demi-circulaire.

3. Dispositif selon l'une ou l'autre des revendications 1 et 2, caractérisé en ce que la distance entre deux régions de cible, séparées électriquement l'une de l'autre, est la même sur la totalité de leur circonférence.

4. Dispositif selon l'une quelconque des revendications 1 à 3, caractérisé en ce que les régions de cible se trouvent au potentiel de la cathode.

5. Dispositif selon l'une quelconque des revendications 1 à 4, caractérisé en ce que l'alimentation en courant peut être appliquée en alternance entre les régions de cible, séparées électriquement les unes des autres.

6. Dispositif selon la revendication 5, caractérisé en ce que, les régions de cible, isolées électriquement les unes des autres, peuvent être soumises en alternance aux demi-ondes successives d'un courant alternatif.

7. Dispositif selon la revendication 6, caractérisé en ce que les demi-ondes se peuvent différer les unes des autres quant à la forme et l'amplitude.

8. Dispositif selon l'une quelconque des revendications 5 à 7, caractérisé en ce que la fréquence du courant alternatif est comprise entre 1 et 100 kHz.

9. Dispositif selon l'une quelconque des revendications 1 à 8, caractérisé en ce que les régions de cible, isolées électriquement les unes des autres, peuvent être raccordées à deux unités d'alimentation en courant continu indépendantes.

10. Dispositif selon l'une quelconque des revendications 1 à 8, caractérisé en ce que le matériau de la cible est composé de silicium pur ou dopé, ou d'un alliage contenant surtout du silicium.

11. Dispositif selon l'une quelconque des revendications 1 à 9, caractérisé en ce que les régions de cible individuelles, fermées en elles-mêmes, sont composées de matériaux de cible différents.
